# EUROPEAN PATENT APPLICATION

(11) **EP 2 418 686 A1**
(43) Date of publication of application: **15.02.2012**
(21) Application number: 10761613.8
(22) Date of filing: 29.03.2010
(51) Int. Cl.: H01L 31/04

(54) **SOLAR CELL AND SOLAR CELL MODULE**

(30) Priority: 09.04.2009 JP 2009095144
(71) Applicant: Sanyo Electric Co., Ltd., Osaka 570-8677 (JP)
(72) Inventor: HASHIMOTO, Haruhisa, Osaka 570-0083 (JP)
(74) Representative: Calderbank, Thomas Roger
(86) International application number: PCT/JP2010/055545
(87) International publication number: WO 2010/116914

(57) **Abstract**

Provided is a solar cell (10) wherein a first cross electrode (13) has a plurality of first protruding sections (13A) which protrude from a first connecting region (R1) to which one wiring member (20) is connected on a light receiving surface in a planar view of the light receiving surface. A second cross electrode (15) has a plurality of second protruding sections (15A) which protrude from a second connecting region (R2) to which other wiring members (20) are connected on the rear surface in a planar view of the rear surface. The first cross electrode (13) and the second cross electrode (15) overlap on a projection plane parallel to the light receiving surface.

## Description

### TECHNICAL FIELD

The present invention relates to a solar cell to which a wiring member is connected and relates to a solar cell module provided with the solar cell.

### BACKGROUND ART

A solar cell is expected as a new energy source because it can directly convert light from the sun, which is clean and inexhaustible sunlight energy, into electricity.

Output per solar cell is as small as several W. Accordingly, when used for power sources of houses or buildings, such solar cells are generally used as a solar cell module in which the output is increased by electrically connecting a plurality of solar cells by means of a wiring member.

Generally, a solar cell is provided with, on a photovoltaic converting unit, a plurality of thin line electrodes for collecting carriers and a connecting electrode for connecting a wiring member. The wiring member is soldered on the connecting electrode. The thin line electrode and the connecting electrode are formed from a thermosetting or sintering conductive paste.

Here, in Patent Literature 1, a technique to let a wiring member adhere to a connecting electrode using a resin adhesive material which is capable of adhering at a temperature lower than soldering is proposed. According to this technique, since expansion and contraction of the wiring member during the connection can be reduced, bending of a solar cell can be suppressed.

### CITATION LIST

### PATENT LITERATURE

Patent Literature 1: Japanese Patent Application Publication No. 2007-214533

### SUMMARY OF THE INVENTION

However, in the technique described in Patent Literature 1, since the photovoltaic converting unit and the connecting electrode are different in coefficient of linear expansion, there is a problem that bending occurs in the solar cell under the influence of heat during the formation of the connecting electrode especially when the thickness of substrate is reduced.

In order to solve this problem, it is considered to reduce the width of the connecting electrode to smaller than the width of the wiring member. However, if the width of the connecting electrode is reduced, there is a possibility that, when connecting the wiring member to the connecting electrode, the wiring member is arranged at a position misaligned with the connecting electrode. In this case, since the shearing stress is applied to the connecting electrode, increased pressure is applied locally to the photovoltaic converting unit. As a result, since a defect, such as a crack, is caused in the photovoltaic converting unit, the characteristics of the solar cell are degraded.

In order to increase positional accuracy of the wiring member, it is necessary to increase precision of a locating device of the connecting electrode and precision of a locating device of the wiring member, whereby the manufacturing cost of the solar cell module is increased.

The present invention is made in view of the above-described circumstances and an object thereof is to provide a solar cell and a solar cell module of which degradation in characteristics can be suppressed.

A feature of the present invention is summarized as a solar cell connected with first and second wiring members, including: a first main surface; a second main surface; a plurality of first thin line electrodes formed on the first main surface; a first cross electrode which crosses the plurality of first thin line electrodes on the first main surface; a plurality of second thin line electrodes formed on the second main surface; and a second cross electrode which crosses the plurality of second thin line electrodes on the second main surface, wherein: the first cross electrode includes a plurality of first protruding sections each protruded from, in a plan view of the first main surface, a first connecting region which is a region to which the first wiring member is connected on the first main surface; the second cross electrode includes a plurality of second protruding sections each protruded from, in a plan view of the second main surface, a second connecting region which is a region to which the second wiring member is connected on the second main surface; and the first cross electrode and the second cross electrode overlap one another on a projection plane which is parallel to the first main surface.

In the solar cell according to the feature of the present invention, a line width of the second cross electrode may be greater than a line width of the first cross electrode.

In the solar cell according to the feature of the present invention, the first main surface may be a light-receiving surface which receives light and the second main surface may be a back surface provided on the opposite side of the light-receiving surface.

In the solar cell according to the feature of the present invention, a height of the first cross electrode may be greater than a height of each of the plurality of first thin line electrodes.

In the solar cell according to the feature of the present invention, a height of the second cross electrode may be greater than a height of each of the plurality of second thin line electrodes.

In the solar cell according to the feature of the present invention, a height of each of the plurality of first thin line electrodes may be greater than a height of the first cross electrode.

In the solar cell according to the feature of the present invention, a height of each of the plurality of second thin line electrodes may be greater than a height of the second cross electrode.

A feature of the present invention is summarized as a solar cell which includes a plurality of first thin line electrodes on a first main surface and includes a plurality of second thin line electrodes on a second main surface, including: a zigzag-shaped first cross electrode which crosses each of the plurality of first thin line electrodes; and a zigzag-shaped second cross electrode which crosses each of the plurality of second thin line electrodes, wherein the first cross electrode and the second cross electrode overlap one another when seen in a plan view.

In the solar cell according to the feature of the present invention, a peak of the first cross electrode may be formed to overlap the first thin line electrode.

In the solar cell according to the feature of the present invention, a peak of the second cross electrode may be formed to overlap the second thin line electrode.

A feature of the present invention is summarized as a solar cell module including: solar cells each including a first main surface and a second main surface; a first wiring member arranged along a predetermined direction on the first main surface; a second wiring member arranged along the predetermined direction on the second main surface; a first resin adhesive material formed between the first main surface and the first wiring member; and a second resin adhesive material formed between the second main surface and the second wiring member; wherein: the solar cells each includes: a plurality of first thin line electrodes formed on the first main surface; a first cross electrode which crosses the plurality of first thin line electrodes on the first main surface; a plurality of second thin line electrodes formed on the second main surface; and a second cross electrode which crosses the plurality of second thin line electrodes on the second main surface; the first cross electrode includes a first protruding section protruded from, in a plan view of the first main surface, the first wiring member; the second cross electrode includes a second protruding section protruded from, in a plan view of the second main surface, the second wiring member; and the first cross electrode and the second cross electrode overlap one another on a projection plane which is parallel to the first main surface.

According to the present invention, a solar cell and a solar cell module which can suppress degradation in characteristics can be provided.

### BRIEF DESCRIPTION OF THE DRAWINGS

[Fig. 1] Fig. 1 is a side view of a solar cell module 100 according to an embodiment of the present invention.
[Fig. 2] Fig. 2 is a plan view of a solar cell 10 according to the embodiment of the present invention seen from a iight-receiving surface side.
[Fig. 3] Fig. 3 is a plan view of a solar cell 10 according to the embodiment of the present invention seen from a back surface side.
[Fig. 4] Fig. 4 is a projection drawing of a solar cell 10 on a projection plane which is parallel to the light-receiving surface.
[Fig. 5] Fig. 5 is a sectional view along line A-A of Fig. 2.
[Fig. 6] Fig. 6 is an enlarged plan view of a solar cell string 1 according to the embodiment of the present invention.

### MODES FOR CARRYING OUT THE INVENTION

Next, embodiments of the present invention will be described with reference to the drawings. In the following description of the drawings, the same or similar parts are denoted by the same or similar reference numerals. It should be noted that the drawings are schematic, and dimensional proportions and the like are different from their actual value. Accordingly, specific dimension and the like should be determined with reference to the following description. In addition, it is a matter of course that dimensional relationships and dimensional proportions may be different from one drawing to another in some parts.

### (Schematic structure of solar cell module)

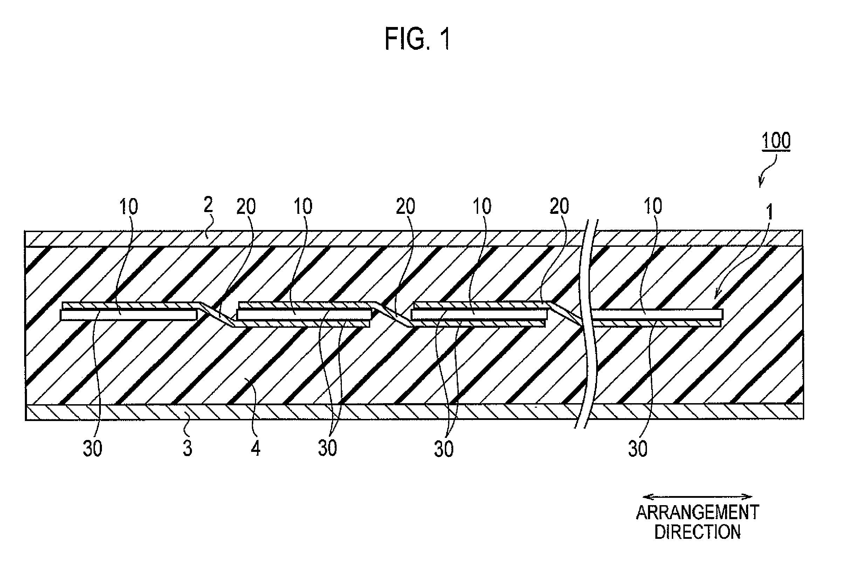

A schematic structure of a solar cell module 100 according to the embodiment will be described with reference to Fig. 1. Fig. 1 is a side view of the solar cell module 100 according to the present embodiment.

The solar cell module 100 is provided with a solar cell string 1, a light-receiving-surface-side protection member 2, a back-surface-side protection member 3 and a sealing material 4. The solar cell module 100 is constituted by sealing the solar cell string 1 between the light-receiving-surface-side protection member 2 and the back-surface-side protection member 3.

The solar cell string 1 is provided with a plurality of solar cells 10, a wiring member 20 and a resin adhesive material 30. The structure of the solar cell string 1 will be described later.

Each of a plurality of solar cells 10 includes a light-receiving surface to which sunlight enters and a back surface provided on the opposite side of the light-receiving surface. The light-receiving surface and the back surface are main surfaces in each of a plurality of solar cells 10. An electrode is formed on the light-receiving surface and on the back surface of each of a plurality of solar cells 10. The structure of the solar cell 10 will be described later.

The wiring member 20 is a wiring member for electrically connecting a plurality of solar cells 10 one another. In particular, one end of the wiring member 20 is arranged on the light-receiving surface of one solar cell 10 along an arrangement direction. The other end of the wiring member 20 is arranged on the back surface of another solar cell 10 along the arrangement direction. The wiring member 20 is connected to the solar cell 10 by a resin adhesive material 30 inserted between the wiring member 20 and a surface of the solar cell 10. The wiring member 20 is preferably constituted by a material with low electrical resistance, such as thin plate-shaped or twisted-shaped copper, silver, gold, tin, nickel, aluminum or alloys thereof. Note that a surface of the wiring member 20 may be covered with a conductive material, such as lead free solder (for example, SnAg₃.₀Cu₀.₅).

The resin adhesive material 30 is formed between the main surfaces (the light-receiving surface and the back surface) of the solar cell 10 and the wiring member 20. As the resin adhesive material 30, for example, a thermosetting resin adhesive material, such as acrylic resin and polyurethane-based resin adhesive material with high flexibility, as well as a two-component adhesive material in which a curing agent is mixed to epoxy resin, acrylic resin or urethane resin can be used.

The resin adhesive material 30 may contain a plurality of fine conductive materials (not illustrated), such as nickel and gold-coated nickel. An example of the resin adhesive material 30 containing such a conductive material is anisotropic conductive adhesive material. The content of the conductive material may preferably be that one or several conductive materials are arranged along the thickness direction after the resin adhesive material 30 is cured. With this, electrical resistance along the thickness direction can be reduced.

If an insulating resin adhesive material 30 is used, the wiring member 20 and the solar cell 10 are electrically connected by letting the surface of the wiring member 20 be in direct contact with a surface of the electrode of the solar cell 10. If a conductive resin adhesive material 30 is used, the surface of the electrode of the solar cell 10 may be in direct contact with the surface of the wiring member 20 via the conductive material.

The light-receiving-surface-side protection member 2 is disposed on the light-receiving surface side of each of a plurality of solar cells 10 and protects a surface of the solar cell module 100. As the light-receiving-surface-side protection member 2, light-transmissive and water-shielding glass, light-transmissive plastic or the like can be used.

The back-surface-side protection member 3 is disposed on the back surface side of each of a plurality of solar cells 10 and protects the back surface of the solar cell module 100. As the back-surface-side protection member 3, a resin film, such as PET (Polyethylene Terephthalate), a laminated film having a structure in which Al foil is sandwiched by the resin films, or the like can be used.

The sealing material 4 seals the solar cell string 1 between the light-receiving-surface-side protection member 2 and the back-surface-side protection member 3. As the sealing material 4, light-transmissive resin, such as EVA, EEA, PVB, silicon, urethane, acrylics and epoxy, can be used.

Note that an Al frame or the like can be attached to an outer circumference of the solar cell module 100 having the above-described structure.

### (Structure of solar cell)

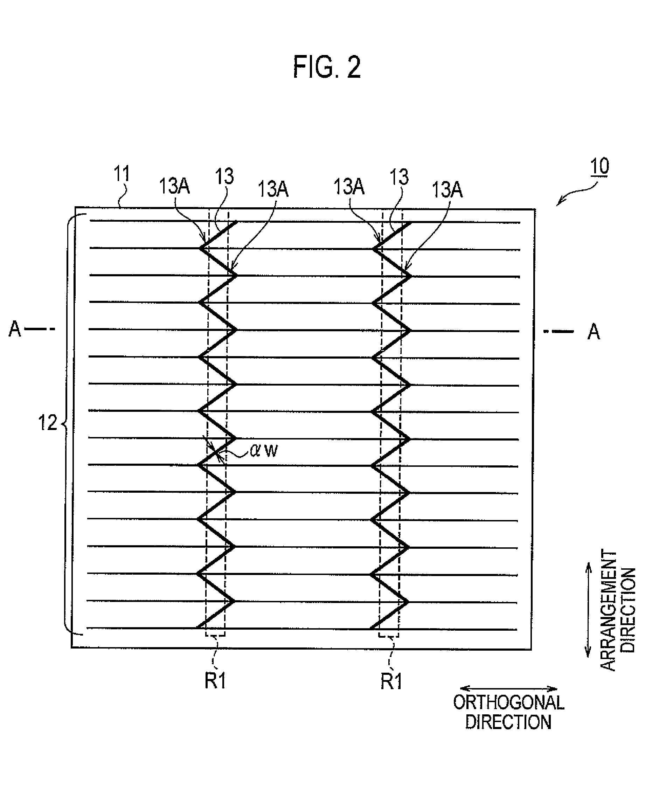

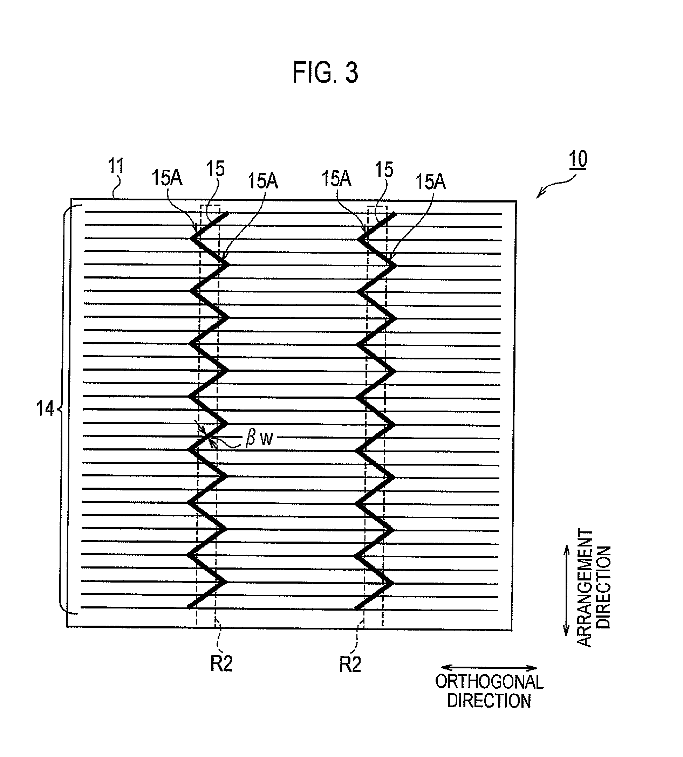

Next, the structure of the solar cell according to the embodiment will be described with reference to the drawings. Fig. 2 is a plan view of the solar cell 10 according to the embodiment seen from the light-receiving surface side. Fig. 3 is a plan view of the solar cell 10 according to the embodiment seen from the back surface side.

As illustrated in Fig. 2, the solar cell 10 includes a photovoltaic converting unit 11, a plurality of first thin line electrodes 12 and a first cross electrode 13.

The photovoltaic converting unit 11 produces a carrier when received light. The carrier refers to a pair of positive hole and electron. The photovoltaic converting unit 11 includes, for example, an n-type region and a p-type region thereinside and a semiconductor junction is formed between the n-type region and the p-type region. The photovoltaic converting unit 11 can be formed using a semiconductor substrate constituted by a crystal semiconductor material, such as single crystal Si and polycrystalline Si, a compound semiconductor material, such as GaAs and InP, or the like. Note that the photovoltaic converting unit 11 may have a structure in which characteristics of a heterojunction interface are improved by inserting a genuine amorphous silicon layer between the single crystal silicon substrate and the amorphous silicon layer, which is called the HIT (registered trademark; SANYO Electric Co., Ltd.) structure.

A plurality of first thin line electrodes 12 are electrodes which collect the carriers from the photovoltaic converting unit 11. Each of a plurality of first thin line electrodes 12 are formed linearly on the light-receiving surface along an orthogonal direction which is perpendicular to the arrangement direction substantially.

On the light-receiving surface, the first cross electrode 13 crosses a plurality of first thin line electrodes 12. The first cross electrode 13 is an electrode which collects the carriers from a plurality of first thin line electrodes 12. In the present embodiment, the first cross electrode 13 is formed in a zigzag shape along the arrangement direction, as illustrated in Fig. 2. The first cross electrode 13 is formed with a uniform line width αw, as illustrated in Fig. 2. The line width αw of the first cross electrode 13 is greater than the line width of the first thin line electrode 12.

The first cross electrode 13 includes a plurality of first protruding sections 13A protruded from a first connecting region R1 which is a region in which one wiring member 20 is connected on the light-receiving surface. In the present embodiment, a plurality of first protruding sections 13A are formed on both orthogonal direction sides of the first connecting region R1. A plurality of first protruding sections 13A are arranged along the arrangement direction.

As illustrated in Fig. 3, the solar cell 10 includes a plurality of second thin line electrodes 14 and a second cross electrode 15.

A plurality of second thin line electrodes 14 are electrodes which collect the carriers from the photovoltaic converting unit 11. Each of a plurality of second thin line electrodes 14 is formed linearly on the back surface along the orthogonal direction. The number of a plurality of second thin line electrodes 14 may be greater than that of a plurality of first thin line electrodes 12.

The second cross electrode 15 crosses a plurality of second thin line electrodes 14 on the back surface. The second cross electrode 15 is an electrode which collects the carriers from a plurality of second thin line electrodes 14. In the present embodiment, the second cross electrode 15 is formed in a zigzag shape along the arrangement direction, as illustrated in Fig. 3. As illustrated in Fig. 3, the second cross electrode 15 is formed with a uniform line width β_{w}; the line width β_{w} is greater than the line width α_{w}. That is, the second cross electrode 15 is formed thicker than the first cross electrode 13. The line width β_{w} of the second cross electrode 15 is greater than the line width of the second thin line electrode 14.

The second cross electrode 15 includes a plurality of second protruding sections 15A protruded from a second connecting region R2 which is a region in which another wiring member 20 is connected on the back surface. In the present embodiment, a plurality of second protruding sections 15A are formed on both orthogonal direction sides of the second connecting region R2. A plurality of second protruding sections 15A are arranged along the arrangement direction.

Note that various electrodes described above can be formed by printing a conductive paste or the like.

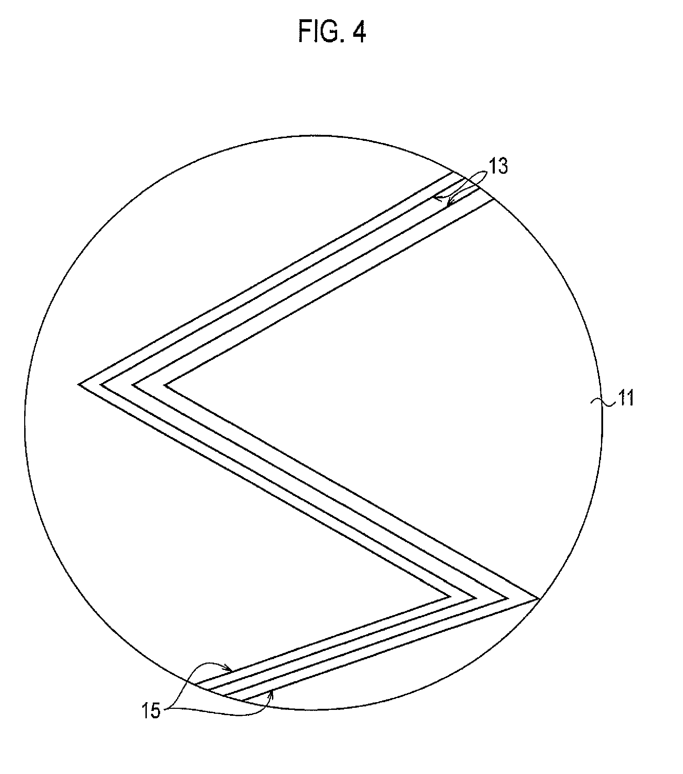

Fig. 4 is a projection drawing of the solar cell 10 on a projection plane which is parallel to the light-receiving surface. However, a plurality of first thin line electrodes 12 and a plurality of second thin line electrodes 14 are omitted in Fig. 4.

As illustrated in Fig. 4, the first cross electrodes 13 and the second cross electrodes 15 overlap one another on the projection plane which is parallel to the light-receiving surface. That is, the first cross electrode 13 and the second cross electrode 15 are formed at position symmetrical with each other via the photovoltaic converting unit 11. In particular, in the present embodiment, since the line width β_{w} is greater than the line width αw, the first cross electrode 13 is formed inside the second cross electrode 15 on the projection plane which is parallel to the light-receiving surface.

As illustrated in Fig. 2 and Fig. 3, a peak of the first protruding section 13A of the first cross electrode 13 overlaps the first thin line electrode 12. A peak of the second protruding section 15A of the second cross electrode 15 overlaps the second thin line electrode 14. As described above, the first cross electrode 13 and the second cross electrode 15 overlap one another on the projection plane which is parallel to the light-receiving surface. That is, in a plan view seen from the light-receiving surface side or the back surface side, the first cross electrode 13 and the second cross electrode 15 overlap one another. Therefore, at least a portion of the second thin line electrode 14 is formed at a position in which that portion overlaps the first thin line electrode 12 in a plan view seen from the light-receiving surface or back surface side.

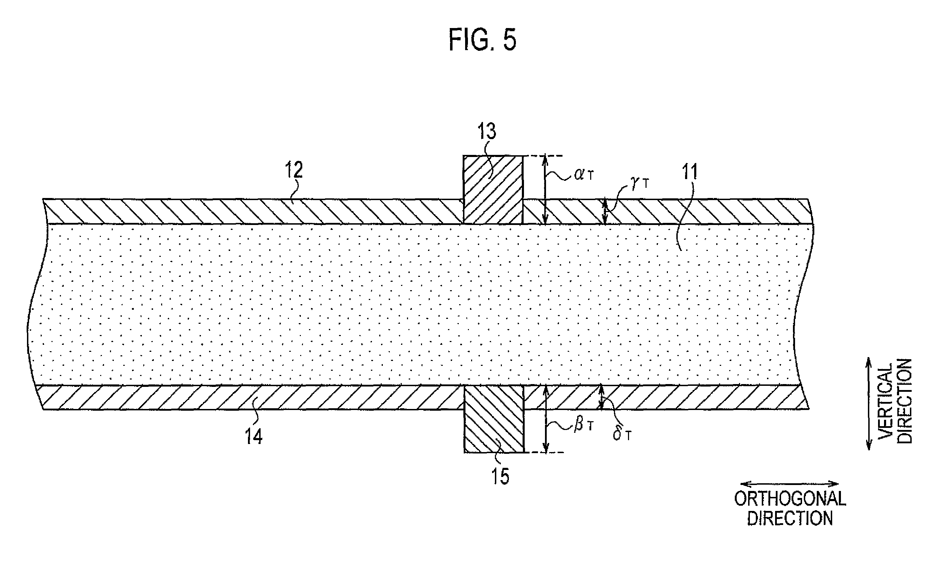

Fig. 5 is a sectional view along line A-A of Fig. 2. As illustrated in Fig. 5, in the vertical direction which is a direction perpendicular to the light-receiving surface, the height αT of the first cross electrode 13 is greater than the height Υ_{T} of the first thin line electrode 12. In the vertical direction, the height β_{T} of the second cross electrode 15 is greater than the height δ_{T} of the second thin line electrode 14.

### (Structure of solar cell string)

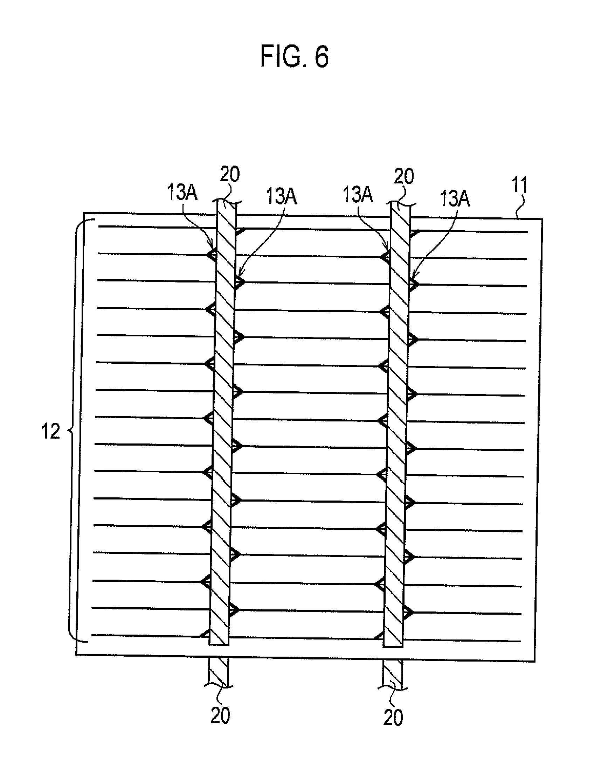

Next, the structure of the solar cell string 1 according to the embodiment will be described with reference to the drawings. Fig. 6 is an enlarged plan view of the solar cell string 1 according to the embodiment seen from the light-receiving surface side.

As illustrated in Fig. 6, one wiring member 20 is arranged on the light-receiving surface of the solar cell 10. One wiring member 20 is arranged on the above-described first connecting region R1 via the resin adhesive material 30. Although not illustrated, another wiring member 20 is arranged on the back surface of the solar cell 10. Another wiring member 20 is arranged on the above-described second connecting region R2 via the resin adhesive material 30.

### (Manufacturing method of solar cell module)

Next, a manufacturing method of the solar cell module 100 according to the present embodiment will be described.

### (1) Solar cell formation process

First, a plurality of photovoltaic converting units 11 are prepared.

Next, a conductive paste, such as an epoxy-based thermosetting silver paste, is printed on the light-receiving surface of the photovoltaic converting unit 11 using a printing method, such as screen printing and offset printing. A printing pattern in this case is, for example, an electrode pattern illustrated in Fig. 2.

Next, a conductive paste, such as an epoxy-based thermosetting silver paste, is printed on the back surface of the photovoltaic converting unit 11 using a printing method, such as screen printing and offset printing. A printing pattern in this case is, for example, an electrode pattern illustrated in Fig. 3.

It should be noted that, in this case, the conductive paste used as the first cross electrode 13 and the second cross electrode 15 are printed to protrude on both orthogonal direction sides of the region in which the wiring member 20 is arranged.

Next, a plurality of first thin line electrodes 12, the first cross electrode 13, a plurality of second thin line electrodes 14 and the second cross electrode 15 are formed by drying the printed conductive paste under a predetermined condition. With this, a plurality of solar cells 10 are produced.

### (2) Solar cell string formation process

Next, a plurality of solar cells 10 are arranged along the arrangement direction and, at the same time, a plurality of solar cells 10 are connected with one another via the wiring member 20.

In particular, first, one wiring member 20 is arranged on the light-receiving surface of the solar cell 10 via a tape-shaped or paste-state resin adhesive material 30 and, at the same time, another wiring member 20 is arranged on the back surface of the solar cell 10 via the resin adhesive material 30. Next, one wiring member 20 is heated while being pressed against the light-receiving surface side and, at the same time, another wiring member 20 is heated while being pressed against the back surface side. With this, the resin adhesive material 30 is cured and each of one wiring member 20 and another wiring member 20 is connected to the solar cell 10. Note that the connection of one wiring member 20 and another wiring member 20 may be performed simultaneously or separately.

### (3) Modularization process step

Next, on a glass substrate (the light-receiving-surface-side protection member 2), an EVA (the sealing material 4) sheet, the solar cell string 1, an EVA (the sealing material 4) sheet and a PET sheet (the back-surface-side protection member 3) are laminated successively to form a laminated product.

Next, the EVA is cured by heating the above-described laminated product under a predetermined condition. In this manner, the solar cell module 100 is produced. A terminal box, an Al frame or the like can be attached to the solar cell module 100.

### (Operation and effect)

In the solar cell 10 according to the embodiment, the first cross electrode 13 includes a plurality of first protruding sections 13A protruded from, in a plan view of the light-receiving surface, the first connecting region R1 to which one wiring member 20 is connected on the light-receiving surface. Accordingly, even if one wiring member 20 is connected to a position misaligned with the first connecting region R1, one wiring member 20 is arranged on a plurality of first protruding sections 13A. Therefore, it is possible to suppress occurrence of a defect, such as a crack, in the solar cell 10 when increased pressure is applied locally to a part of the solar cell 10.

Similarly, in the solar cell 10 according to the embodiment, the second cross electrode 15 includes a plurality of second protruding sections 15A protruded from, in a plan view of the back surface, the second connecting region R2 to which another wiring member 20 is connected on the back surface. Accordingly, even if another wiring member 20 is connected to a position misaligned with the second connecting region R2, another wiring member 20 is arranged on a plurality of second protruding sections 15A. Therefore, it is possible to suppress occurrence of a defect, such as a crack, in the solar cell 10 when increased pressure is applied locally to a part of the solar cell 10.

In the solar cell 10 according to the embodiment, the first cross electrode 13 and the second cross electrode 15 overlap one another on the projection plane which is parallel to the light-receiving surface. Accordingly, when one wiring member 20 and another wiring member 20 are pressed independently against the solar cell 10, it is possible to suppress application of shearing stress to the solar cell 10 between the first cross electrode 13 and the second cross electrode 15. As a result, it is possible to suppress occurrence of a defect, such as a crack, in the solar cell 10.

With the result described above, it is possible to suppress degradation in characteristics in the solar cell 10.

The line width β_{w} of the second cross electrode 15 is greater than the line width αw of the first cross electrode 13. That is, the first cross electrode 13 is formed inside the second cross electrode 15 on the projection plane which is parallel to the light-receiving surface. Accordingly, the tolerance of a printing point of the conductive paste at the time of forming the first cross electrode 13 and the second cross electrode 15 can be increased. Therefore, it is possible to suppress formation of a region in which the first cross electrode 13 and the second cross electrode 15 do not overlap one another on the projection plane which is parallel to the light-receiving surface. Accordingly, it is possible to suppress more reliably application of the shearing stress to the solar cell 10.

Since the line width β_{w} of the second cross electrode 15 formed on the back surface side is greater than the line width αw of the first cross electrode 13 formed on the light-receiving surface side, it is possible to suppress reduction in the area of the light-receiving surface of the solar cell 10.

In the present embodiment, the height α_{T} of the first cross electrode 13 is greater than the height γ_{T} of the first thin line electrode 12. Accordingly, since the expansion and contraction of one wiring member 20 can be absorbed by the first cross electrode 13 extending along the arrangement direction, it is possible to suppress transmission of the expansion and contraction of one wiring member 20 to the photovoltaic converting unit 11. Therefore, it is possible to suppress occurrence of bending in the solar cell 10.

Similarly, in the present embodiment, the height β_{T} of the second cross electrode 15 is greater than the height δ_{T}of the second thin line electrode 14. Accordingly, since the expansion and contraction of another wiring member 20 can be absorbed by the second cross electrode 15 extending along the arrangement direction, it is possible to suppress transmission of the expansion and contraction of another wiring member 20 to the photovoltaic converting unit 11. Therefore, it is possible to more reliably suppress occurrence of bending in the solar cell 10.

### (Other embodiments)

Although the present invention has been described with reference to the above-described embodiment, it should not be understood that the discussion and the drawings which constitute a part of the present invention is restrictive to the invention. Various alternatives, examples and operational techniques will be clear to a person skilled in the art from this disclosure.

For example, although the first cross electrode 13 and the second cross electrode 15 are formed in a zigzag shape along the arrangement direction in the above-described embodiment, this is not restrictive. The planar shapes of the first cross electrode 13 and the second cross electrode 15 can be determined appropriately.

Although the first protruding section 13A is bent outside the first connecting region R1 in the above-described embodiment, this is not restrictive. For example, the first protruding section 13A may be curved. Similarly, the second protruding section 15A may be curved outside the second connecting region R2.

Although the first cross electrode 13 is formed with a uniform line width αw in the above-described embodiment, it is not necessary that the line width of the first cross electrode 13 is uniform. Similarly, it is not necessary that the line width of the second cross electrode 15 is uniform. In the present invention, it suffices that the first cross electrode 13 and the second cross electrode 15 overlap one another on the projection plane which is parallel to the light-receiving surface. Accordingly, the line width αw of the first cross electrode 13 may be formed greater than the line width β_{w} of the second cross electrode 15 or the line width αw and the line width β_{w} may be substantially equal to each other.

Although not described in the above-described embodiment, each of the various electrodes may be in direct contact with the wiring member 20, or may need not be in direct contact with the wiring member 20. If each of the various electrodes is in direct contact with the wiring member 20, the resin adhesive material 30 may need not have conductivity. If each of the various electrodes is not in direct contact with the wiring member 20, it is preferred that the resin adhesive material 30 is conductive.

Although the height α_{T} of the first cross electrode 13 is greater than the height γ_{T} of the first thin line electrode 12 and the height β_{T} of the second cross electrode 15 is greater than the height δ_{T} of the second thin line electrode 14, this is not restrictive. The height α_{T} of the first cross electrode 13 may be equal to the height γ_{T} of the first thin line electrode 12. The height β_{T} of the second cross electrode 15 may be equal to the height δ_{T} of the second thin line electrode 14. The height γ_{T} of the first thin line electrode 12 may be greater than the height α_{T} of the first cross electrode 13. The height δ_{T} of the second thin line electrode 14 may be greater than the height β_{T} of the second cross electrode 15. Especially since it is possible to reduce the distance between one wiring member 20 and the first thin line electrode 12 when the height γ_{T} of the first thin line electrode 12 is greater than the height α_{T} of the first cross electrode 13, resistance between one wiring member 20 and the first thin line electrode 12 can be reduced. Since it is possible to reduce the distance between another wiring member 20 and the second thin line electrode 14 when the height δ_{T}of the second thin line electrode 14 is greater than the height β_{T} of the second cross electrode 15, resistance between another wiring member 20 and the second thin line electrode 14 can be reduced.

As described above, it is of course that the present invention includes various embodiments or the like that are not described herein. Accordingly, the technical scope of the present invention is defined only by the matter to define the invention related to the claims that is reasonable from the above description.

### EXAMPLES

The solar cell module according to the present invention will be specifically described below with reference to the examples. However, the present invention is not limited to those described in the following examples, and can be implemented with alternations made as appropriate within the scope of the invention.

### (Example)

First, a plurality of photovoltaic converting units (125 mm in square and 200 micrometers in thickness) having a structure which is called the HIT (registered trademark; SANYO Electric Co., Ltd.) structure were prepared.

Next, a plurality of thin line electrodes and a plurality of cross electrodes were formed by printing a silver paste by means of offset printing on a light-receiving surface of each of a plurality of photovoltaic converting units. A formed pattern of both the electrodes was the pattern illustrated in Fig. 2. On the light-receiving surface, a preferred size of the thin line electrode is 60 to 90 micrometers in width and 30 to 60 micrometers in height, and a preferred size of the cross electrode is 80 to 150 micrometers in width and 40 to 70 micrometers in height. Note that the width of the cross electrode is greater than the width of the thin line electrode.

Next, a conductive paste on the light-receiving surface was dried under a predetermined condition.

Next, a plurality of thin line electrodes and a plurality of cross electrodes were formed by printing a silver paste by means of offset printing on the back surface of each of a plurality of photovoltaic converting units. A formed pattern of both the electrodes was the pattern illustrated in Fig. 3. On the back surface, a preferred size of the thin line electrode is 80 to 120 micrometers in width and 25 to 50 micrometers in height, and a preferred size of the cross electrode is 100 to 300 micrometers in width and 30 to 60 micrometers in height. Accordingly, the cross electrodes on the light-receiving surface and the cross electrodes on the back surface overlap one another on the entire region on the projection plane which is parallel to the light-receiving surface. Subsequently, the conductive paste on the back surface was dried under a predetermined condition. With this, a plurality of solar cells are formed.

Next, a plurality of solar cells were connected to one another using a wiring member (line width; 1.5 mm). In particular, the wiring member was arranged on thermosetting epoxy resin applied on the light-receiving surface and the back surface of each solar cell by means of a dispenser, and the wiring member was heated and attached to the solar cell with pressure. With this, a solar cell string was formed.

### (Comparative example)

In Comparative example, the cross electrodes on the light-receiving surface and the cross electrodes on the back surface do not overlap one another in the entire region on the projection plane which is parallel to the light-receiving surface by forming the cross electrodes in a formed pattern which is different from that of Example. Other processes were the same as those of Example 1.

### (Yield)

The yield of the solar cell string according to Example was 98%. On the other hand, the yield of the solar cell string according to Comparative Example was 85%. Note that the solar cell string in which a crack, a chip, bending or the like occurred in the solar cell was defined as a defective article.

Such a result was obtained in Example since the cross electrodes on the light-receiving surface side and the cross electrodes on the back surface side were formed symmetrical with one another via the photovoltaic converting unit, it was possible to suppress occurrence of shearing stress between both the cross electrodes when the wiring member was pressed against the solar cell.

On the other hand, in Comparative Example, since the cross electrodes on the light-receiving surface side and the cross electrodes on the back surface side were not formed symmetrical with one another via the photovoltaic converting unit, a crack or the like occurred in the solar cell due to shearing stress generated between both the cross electrodes.

The entire content of Japanese Patent Application No. 2009-095144 (filed on April 9, 2000) is incorporated to the specification of the present application by reference.

### Industrial Applicability

As described above, the solar cell and the solar cell module according to the present invention are useful in the field of manufacturing a solar cell and a solar cell module since degradation in characteristics can be suppressed.

1... solar cell string, 2...light-receiving-surface-side protection member, 3...back-surface-side protection member, 4...sealing material, 10...solar cell, 11... photovoltaic converting unit, 12...first thin line electrode, 13...first cross electrode, 13A...first protruding sections, 14 ...second thin line electrode, 15 ... second cross electrode, 15A... second protruding sections, 20...wiring member, 30...resign adhesive material, 100... solar cell module

## Claims

1. A solar cell connected with first and second wiring members, the solar cell comprising:
a first main surface;
a second main surface;
a plurality of first thin line electrodes formed on the first main surface;
a first cross electrode which crosses the plurality of first thin line electrodes on the first main surface;
a plurality of second thin line electrodes formed on the second main surface; and
a second cross electrode which crosses the plurality of second thin line electrodes on the second main surface,
wherein:
the first cross electrode includes a plurality of first protruding sections each protruded from, in a plan view of the first main surface, a first connecting region which is a region to which the first wiring member is connected on the first main surface;
the second cross electrode includes a plurality of second protruding sections each protruded from, in a plan view of the second main surface, a second connecting region which is a region to which the second wiring member is connected on the second main surface; and
the first cross electrode and the second cross electrode overlap one another on a projection plane which is parallel to the first main surface.

2. The solar cell according to claim 1, wherein a line width of the second cross electrode is greater than a line width of the first cross electrode.

3. The solar cell according to claim 2, wherein the first main surface is a light-receiving surface which receives light and the second main surface is a back surface provided on the opposite side of the light-receiving surface.

4. The solar cell according to claim 1, wherein a height of the first cross electrode is greater than a height of each of the plurality of first thin line electrodes.

5. The solar cell according to claim 1, wherein a height of the second cross electrode is greater than a height of each of the plurality of second thin line electrodes.

6. The solar cell according to claim 1, wherein a height of each of the plurality of first thin line electrodes is greater than a height of the first cross electrode.

7. The solar cell according to claim 1, wherein a height of each of the plurality of second thin line electrodes is greater than a height of the second cross electrode.

8. A solar cell which includes a plurality of first thin line electrodes on a first main surface and includes a plurality of second thin line electrodes on a second main surface, the solar cell comprising:
a zigzag-shaped first cross electrode which crosses each of the plurality of first thin line electrodes; and
a zigzag-shaped second cross electrode which crosses each of the plurality of second thin line electrodes,
wherein the first cross electrode and the second cross electrode overlap one another when seen in a plan view.

9. The solar cell according to claim 8, wherein a peak of the first cross electrode is formed to overlap the first thin line electrode.

10. The solar cell according to claim 8, wherein a peak of the second cross electrode is formed to overlap the second thin line electrode.

11. A solar cell module comprising:
solar cells each including a first main surface and a second main surface;
a first wiring member arranged along a predetermined direction on the first main surface;
a second wiring member arranged along the predetermined direction on the second main surface;
a first resin adhesive material formed between the first main surface and the first wiring member; and
a second resin adhesive material formed between the second main surface and the second wiring member;
wherein:
the solar cells each includes:
a plurality of first thin line electrodes formed on the first main surface;
a first cross electrode which crosses the plurality of first thin line electrodes on the first main surface;
a plurality of second thin line electrodes formed on the second main surface; and
a second cross electrode which crosses the plurality of second thin line electrodes on the second main surface;
the first cross electrode includes a first protruding section protruded from, in a plan view of the first main surface, the first wiring member;
the second cross electrode includes a second protruding section protruded from, in a plan view of the second main surface, the second wiring member; and
the first cross electrode and the second cross electrode overlap one another on a projection plane which is parallel to the first main surface.
